(19) Europäisches Patentamt
European Patent Office
Office européen des brevets

(11) **EP 4 339 631 B1**

(12) **EUROPEAN PATENT SPECIFICATION**

(45) Date of publication and mention
of the grant of the patent:
**21.01.2026  Bulletin 2026/04**

(21) Application number: **21941156.8**

(22) Date of filing: **10.05.2021**

(51) International Patent Classification (IPC):
***G01R 31/34*** *(2020.01)*

(52) Cooperative Patent Classification (CPC):
**G01R 31/343**

(86) International application number:
**PCT/CN2021/092776**

(87) International publication number:
**WO 2022/236580 (17.11.2022 Gazette 2022/46)**

(54) **METHOD AND DEVICE FOR TESTING PEAK PERFORMANCE OF MOTOR**

VERFAHREN UND VORRICHTUNG ZUM TESTEN DER SPITZENLEISTUNG EINES MOTORS

PROCÉDÉ ET DISPOSITIF POUR TESTER LES PERFORMANCES MAXIMALES D'UN MOTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**20.03.2024  Bulletin 2024/12**

(73) Proprietor: **Schaeffler Technologies AG & Co. KG**
**91074 Herzogenaurach (DE)**

(72) Inventors:
• **LI, Jiahao**
  **Suzhou, Jiangsu 215332 (CN)**
• **HU, Liang**
  **Suzhou, Jiangsu 215300 (CN)**
• **GONG, Yu**
  **Shanghai 200129 (CN)**

(74) Representative: **Schaeffler Technologies**
**Industriestraße 1-3**
**91074 Herzogenaurach (DE)**

(56) References cited:
**CN-A- 101 603 997     CN-A- 101 603 997**
**CN-A- 102 490 614     CN-A- 102 490 614**
**CN-A- 103 762 911     CN-A- 103 762 911**
**CN-A- 111 431 459     US-A- 4 422 040**

**Description**

<u>Technical Field</u>

The present invention relates to the technical field of motors, and particularly relates to a method and device for testing peak performance of a motor.

<u>Background</u>

In related art, in certain scenarios, for example, in the scenario where users need to understand performance of a motor in order to select a suitable motor whose performance meets their needs, the performance of the motor needs to be tested before the motor leaves the factory.

Existing methods for testing the performance of a motor may only consider voltage and current limitations, however, the requirements of new energy electric vehicles for the peak performance also typically comprise a sufficient duration (10-30 seconds) at each rotational speed within an allowable temperature rise range (depending on an insulation level of a winding). Currently, most such motors use rectangular flat wires due to high slot fill rates and good quality control. However, since the rectangular flat wires have a strong skin effect at high speeds, the current density in conductors in a stator slot is severely uneven, which will lead to a higher temperature rise of the motor at high speeds. Traditional methods for estimating the peak performance may not be able to consider the higher temperature rise at high speeds Prior art can be found in document CN102490614A.

<u>Summary</u>

In view of this, the present invention provides a method and device for testing peak performance of a motor.

In order to solve the above technical problems, according to an embodiment of the present invention, the method for testing the peak performance of the motor is provided, which is applied to a flat wire motor of a new energy vehicle. The method comprises: a setting and testing step of setting a maximum allowable power supply current of the motor, and testing the peak performance of the motor by using the set maximum allowable power supply current; an adjustment step of adjusting the set maximum allowable power supply current when a rotational speed of the motor reaches a predetermined rotational speed in the process of testing the performance of the motor according to the set maximum allowable power supply current, such that the current decreases with an increase of the rotational speed of the motor; and a continuous testing step of continuing to test the peak performance of the motor by using the adjusted maximum allowable power supply current.

In order to solve the above technical problems, according to another embodiment of the present invention, the device for testing the peak performance of the motor is provided, which is applied to the flat wire motor of the new energy vehicle. The device comprises: a setting and testing module, used for setting a maximum allowable power supply current of the motor, and testing the peak performance of the motor by using the set maximum allowable power supply current; an adjustment module, connected to the setting and testing module, and used for adjusting the set maximum allowable power supply current when a rotational speed of the motor reaches a predetermined rotational speed in the process of testing the performance of the motor according to the set maximum allowable power supply current, such that the current decreases with an increase of the rotational speed of the motor; and a continuous testing module, connected to the adjustment module, and used for continuing to test the peak performance of the motor by using the adjusted maximum allowable power supply current.

According to the method and device for testing the peak performance of the motor in the present invention, the peak performance of the motor is tested by using the set maximum allowable power supply current, during which if the rotational speed of the motor reaches the predetermined rotational speed, the set maximum allowable power supply current decreases with the increase of the rotational speed of the motor, and the adjusted maximum allowable power supply current is used for continuing to test the peak performance of the motor.

Therefore, compared with the prior art which only considers current and/or voltage limitations without considering the skin effect when testing the peak performance of the motor, the present invention not only considers the current limitation but also considers the skin effect when testing the peak performance of the motor. Hence, by decreasing the maximum allowable power supply current applied to the motor when the rotational speed of the motor reaches the predetermined rotational speed, a maximum copper loss density can be maintained substantially constant with the increase of the rotational speed of the motor.

Other features and aspects of the present invention will become clear according to the following detailed descriptions of exemplary embodiments with reference to drawings.

Brief Description of the Drawings

The drawings included in the specification and constituting a part thereof together with the specification illustrate exemplary embodiments, features, and aspects of the present invention, and are used to explain the principles of the present invention.

FIG. 1 is a flow chart of a method for testing peak performance of a motor in the related art.

FIG. 2 is a flow chart of a method for testing peak performance of a motor according to an exemplary embodiment.

FIG. 3 is an exemplary flow chart of the method for testing the peak performance of the motor according to an exemplary embodiment.

FIG. 4 is a schematic diagram of comparison of the peak performance of the motor after applying the methods for testing the peak performance of the motor in the present embodiment and the related art.

FIG. 5 is a schematic diagram of comparison of the copper loss density in last conductors of stator slots after applying the methods for testing the peak performance of the motor in the present embodiment and the related art.

FIG. 6 is a block diagram of an engine start control device for a hybrid electric vehicle illustrated according to an exemplary embodiment.

Detailed Description

Various exemplary embodiments, features and aspects of the present invention will be described in detail below with reference to the drawings. The same reference numerals in the drawings indicate elements with the same or similar functions. Although various aspects of the embodiments are shown in the drawings, the drawings are not necessarily drawn to scale unless otherwise specified.
The dedicated word "exemplary" herein means "serving as an example and an embodiment, or being illustrative". Any embodiment described herein as "exemplary" is not necessarily construed as being superior to or better than other embodiments.
In addition, in order to better illustrate the present invention, numerous specific details are given in the following specific embodiments. Those skilled in the art will understand that the present invention can also be implemented without certain specific details. In some other examples, the methods, means, elements and circuits that are well known to those skilled in the art have not been described in detail, so as to highlight the gist of the present invention.
It should be understood that conductors will be affected by a skin effect. When there is an alternating current or alternating electromagnetic field in conductors, the current inside the conductors is unevenly distributed, and the current is concentrated in "skin" parts of the conductors, that is to say, the current is concentrated in thin layers on the surfaces of the conductors, the closer to the surfaces of the conductors, the greater the current density, and the current inside a wire is actually small, which results in an increase in the resistance of the conductors and an increase in power loss of the conductors. This phenomenon can be called the skin effect. It is obvious that the skin effect causes a great waste of current, and incapability of efficient utilization also causes a great waste of energy.

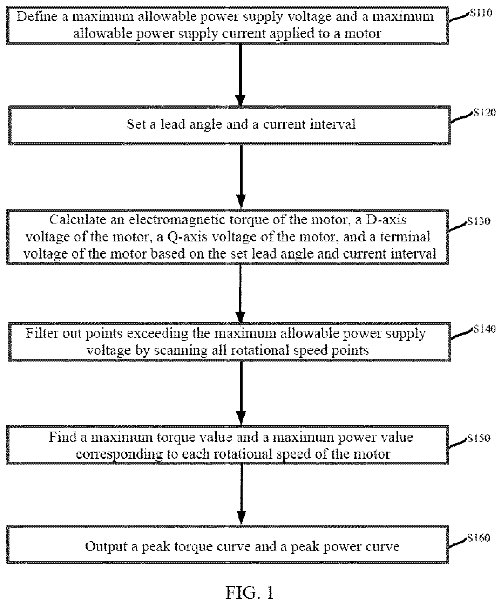

FIG. 1 is a flow chart of a method for testing peak performance of a motor in the related art. In the related art, the peak performance of the motor can be tested by the method for testing the peak performance of the motor as shown in FIG. 1. The method for testing the peak performance comprises:

In step S110, a maximum allowable power supply voltage ($U_m$) and a maximum allowable power supply current ($I_m$) applied to the motor are defined according to a battery capacity and a capacity of a power electronic unit (PEU for short).

In step S120, a lead angle and a current interval are set, that is, the lead angle $\theta$ and a current step size are set, wherein

$\tan(\theta) = i_d / i_q$, $I_s \leq I_m$, $I_s = \sqrt{i_d^2 + i_q^2}$, $i_d$ is a D-axis output current (that is, a D-axis component of a stator current), and $i_q$ is a Q-axis output current (that is, a Q-axis component of the stator current).

In step S130, an electromagnetic torque ($T_e$) of the motor, a D-axis voltage ($U_d$) of the motor, a Q-axis voltage ($U_q$) of the motor, and a terminal voltage ($U_s$) of the motor are calculated based on the lead angle and the current interval set in step S120. That is, according to the set step size, the D-axis component of the stator voltage $U_d$, the Q-axis components of the stator voltage $U_q$, $U_s$, and $T_e$ corresponding to each current are calculated. In one possible implementation, $U_d$, $U_q$, $U_s$, and $T_e$ can be calculated by employing the following Equation 1, Equation 2, Equation 3, and Equation 4:

$$T_e = \frac{3}{2} P_n i_q \left[ i_d \left( L_d - L_q \right) + \varphi_f \right] \qquad \text{Equation 1}$$

$$U_d = -w_e L_q i_q \qquad \text{Equation 2}$$

$$U_q = w_e \left( L_d i_d + \varphi_f \right) \qquad \text{Equation 3}$$

$$U_s = \sqrt{U_d^2 + U_q^2} = \sqrt{(w_e L_q i_q)^2 + \left[ w_e \left( L_d i_d + \varphi_f \right) \right]^2} = w_e \sqrt{(L_q i_q)^2 + (L_d i_d + \varphi_f)^2} \qquad \text{Equation 4}$$

wherein $P_n$ is a number of pole pairs of the motor, $L_d$ is a D-axis motor inductance, $L_q$ is a Q-axis motor inductance, $\varphi_f$ is a permanent magnet flux linkage of the motor, and $w_e$ is an electrical angle of a first intersection point B of a maximum torque-to-voltage ratio control curve and a current limit circle of the motor.

In step S140, points exceeding the maximum allowable power supply voltage $U_m$ are filtered out by scanning all rotational speed points. That is, all rotational speed points that satisfy $U_s > U_m$ are deleted.

In step S150, a maximum torque value and a maximum power value corresponding to each rotational speed of the motor are found.

In step S160, a peak torque curve and a peak power curve are outputted. The maximum torque values of all rotational speed points can be connected into a curve, and the curve is the peak torque curve; and accordingly, the maximum power values of all rotational speed points can be connected into a curve, and the curve is the peak power curve.

However, the above method for testing the performance of the motor may only consider the voltage and current limitations, e.g., only consider the maximum allowable power supply voltage $U_m$ and the maximum allowable power supply current $I_m$ applied to the motor, without considering the skin effect, thereby possibly leading to an uneven current density in conductors in a stator slot.

Specifically, the requirements of new energy electric vehicles for the peak performance also typically comprise a sufficient duration (10-30 seconds) at each rotational speed of the motor within an allowable temperature rise range (depending on an insulation level of a winding). Currently, most such motors use rectangular flat wires due to high slot fill rates and good quality control. However, since rectangular flat wires have a strong skin effect at high speeds, the current density of the conductors in the stator slot is severely uneven, which will lead to a higher temperature rise of the motor at high speeds, thereby leading to the incapability of maintaining a maximum copper loss density constant with an increase of the rotational speed of the motor.

To this end, the present invention realizes that: in the process of testing the performance of the motor, the maximum allowable power supply current used in the process of testing the performance of the motor can decrease in the case that the rotational speed of the motor reaches a certain rotational speed value, thereby enabling the maximum copper loss density to be maintained substantially constant with the increase of the rotational speed of the motor.

Specifically, the present invention provides the method and device for testing the performance of the motor. The peak performance (e.g., peak torque, peak power, etc.) of the motor is tested by using the set maximum allowable power supply current, during which if the rotational speed of the motor reaches the predetermined rotational speed, the set maximum allowable power supply current is adjusted, such that the maximum allowable power supply current decreases with the increase of the rotational speed of the motor, and then the adjusted maximum allowable power supply current is used for continuing to test the peak performance of the motor.

Hence, when the peak performance of the motor is tested, not only the current limitation but also the skin effect are considered, and by decreasing the maximum allowable power supply current applied to the motor with the increase of the rotational speed of the motor, the maximum copper loss density can be maintained substantially constant with the increase of the rotational speed of the motor.

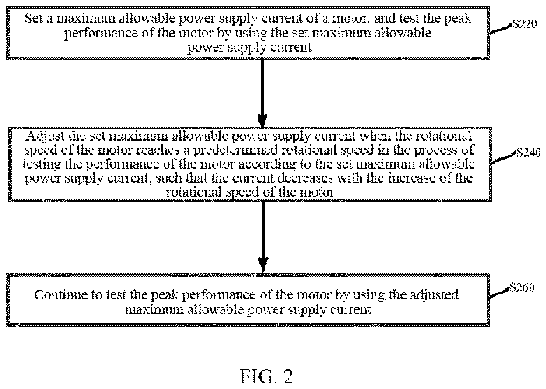

In order to better understand the present invention, the method for testing the performance of the motor of the present invention will be described in detail below in conjunction with the flow chart shown in FIG. 2.

FIG. 2 is a flow chart of the method for testing the performance of the motor according to an exemplary embodiment. The method for testing the performance of the motor can be applied to a flat wire motor of a new energy vehicle, wherein the flat wire motor may refer to a motor using flat wires, e.g., rectangular flat wires. In one implementation, the new energy vehicle may comprise a motor and a controller thereof (i.e., a motor controller), and the motor controller can test the performance of the flat wire motor of the new energy vehicle by adopting the method for testing the performance of the motor of the present invention. As shown in FIG. 2, the method for testing the performance of the motor may comprise the following steps.

In step S220, a maximum allowable power supply current $I_m$ of the motor is set, and the peak performance of the motor is tested by using the set maximum allowable power supply current $I_m$. Step S220 corresponds to a setting and testing step.

In the present embodiment, the maximum allowable power supply current $I_m$ of the motor is the maximum allowable power supply current that the motor controller can apply to the motor. It should be understood that the greater the current the motor controller applies to the motor, the shorter the duration of the current, so it is necessary to set the maximum allowable power supply current $I_m$ within a specified time to limit the current outputted by the motor controller, thereby preventing a too short duration caused by an excessive current.

In one possible implementation, the motor controller may set the maximum allowable power supply current of the motor based on parameters related to the current limitation of the motor.

In the present embodiment, the parameters related to the current limitation of the motor may comprise, but be not limited to, parameters affecting the current that the motor controller can output, e.g., a battery capacity, a capacity of a power electronic unit, etc. In one possible implementation, the motor controller may set the maximum allowable power supply current $I_m$ applied to the motor based on the battery capacity and the capacity of the power electronic unit as the parameters related to the current limitation of the motor.

After the maximum allowable power supply current $I_m$ is set, the motor controller can test the peak performance of the motor by using the set maximum allowable power supply current $I_m$. The peak performance of the motor comprises, but is not limited to, a peak torque and a peak power. Testing the peak performance of the motor may comprise, but be not limited to, outputting a curve or a distribution histogram, etc. corresponding to the peak performance of the motor, so that a user can more conveniently view the peak performance of the motor.

Exemplarily, a peak torque curve may be a peak torque curve formed by connecting multiple points with the rotational speeds of the motor as the abscissa and the maximum torque values of the motor as the ordinate, or a peak torque distribution histogram drawn based on the rotational speeds and the maximum torque values corresponding thereto. Accordingly, a peak power curve may be a peak power curve formed by connecting multiple points with the rotational speeds of the motor as the abscissa and the maximum power values of the motor as the ordinate, or a peak power distribution histogram drawn based on the rotational speeds and the maximum power values corresponding thereto.

In step S240, the set maximum allowable power supply current $I_m$ is adjusted when the rotational speed of the motor $n$ reaches a predetermined rotational speed $n_b$ in the process of testing the performance of the motor according to the set maximum allowable power supply current $I_m$, such that the current decreases with the increase of the rotational speed of the motor. Step S240 corresponds to an adjustment step.

In the present embodiment, in the process of testing the peak performance of the motor according to the set maximum allowable power supply current $I_m$ in above step S220, the motor controller may obtain the rotational speed of the motor $n$. In one possible implementation, the motor controller may obtain the rotational speed of the motor through, for example, a rotational speed sensor arranged on the motor.

The motor controller may judge whether the obtained rotational speed $n$ reaches the predetermined rotational speed $n_b$. In one possible implementation, the motor controller may compare the obtained rotational speed $n$ with the predetermined rotational speed $n_b$. If the obtained rotational speed $n$ is greater than or equal to the predetermined rotational speed $n_b$, the motor controller judges that the obtained rotational speed $n$ has reached the predetermined rotational speed $n_b$.

The setting manners of the predetermined rotational speed $n_b$ comprise, but are not limited to, setting based on actual test results or setting based on experience of engineers. In one possible implementation, the rotational speed of the motor when the actually measured copper loss density reaches the maximum allowable value may be set as the predetermined rotational speed $n_b$. Specifically, if it is found through actual testing that at a certain rotational speed, a short-term temperature rise reaches the maximum allowable value, the copper loss density at the time reaches the maximum allowable value, and the rotational speed at the time may be set as the predetermined rotational speed $n_b$. In another possible implementation, the predetermined rotational speed set by the engineers based on the experience may be obtained and used as the predetermined rotational speed $n_b$.

In the case that it is judged that the obtained rotational speed $n$ has reached the predetermined rotational speed $n_b$, it means that the copper loss density at the time has reached the maximum allowable value. In this case, the motor controller needs to decrease the set maximum allowable power supply current $I_m$ to maintain the copper loss density substantially unchanged. In other words, in the above case, the motor controller may adjust the set maximum allowable power supply current $I_m$ in step S220 in an adjustment manner that the set maximum allowable power supply current $I_m$ in

above step S220 decreases with the increase of the rotational speed $n$ of the motor. The adjusted maximum allowable power supply current is $I'_m$.

It should be understood that in the case that it is judged that the obtained rotational speed $n$ has reached the predetermined rotational speed $n_b$, the motor controller may decrease the maximum allowable power supply current according to the rotational speed $n$ of the motor. The present invention does not impose specific restrictions on how to decrease the maximum allowable power supply current and/or what value the maximum allowable power supply current decreases to. Any decreasing manner and any value allowing to decrease the maximum allowable power supply current to enable the copper loss density to be maintained substantially constant can be applied to the present invention.

In one possible implementation, the maximum allowable power supply current may be decreased by the following manners: calculating a ratio of the height of conductors in a stator slot of the motor to the skin depth; calculating a target maximum allowable power supply current based on the ratio, identification of the conductors, and the set maximum allowable power supply current; and adjusting the set maximum allowable power supply current to the calculated target maximum allowable power supply current, wherein the target maximum allowable power supply current is less than the set maximum allowable power supply current.

In the present embodiment, as mentioned above, when the rotational speed of the motor reaches the predetermined rotational speed, the maximum copper loss density will be unable to maintain constant with the increase of the rotational speed of the motor due to the skin effect. Therefore, in order to maintain the maximum copper loss density substantially constant, the skin effect needs to be considered when the rotational speed of the motor reaches the predetermined rotational speed. Therefore, the motor controller may obtain the height of the conductors in the stator slot and the skin depth corresponding thereto, and calculate the ratio of the two.

Corresponding conductors are disposed at corresponding positions of the stator slot, and the conductors disposed at different positions have different kinds of identification. Therefore, the identification of the conductors may also indicate the positions of the conductors in the stator slot. It should be understood that the skin depth may represent the depth at which the current density in the conductors decreases to 1/e (e is the natural base e=2.71828183) of the current density on the surfaces of the cross sections of the conductors, which is not limited in the present invention and depends on the specific situation.

The motor controller may calculate a decreasing amplitude (also referred to as a decreasing coefficient) based on the calculated ratio of the height of the conductors to the skin depth and the identification of the conductors, and may apply the decreasing amplitude to the set maximum allowable power supply current in step S220 to decrease the maximum allowable power supply current.

In one implementation, the maximum allowable power supply current may decrease by performing a multiplication operation on the decreasing amplitude and the set maximum allowable power supply current in step S220, and in this case, the decreasing amplitude should be less than 1; the maximum allowable power supply current may also decrease by performing a subtraction operation on the decreasing amplitude and the set maximum allowable power supply current in step S220; and the maximum allowable power supply current may also decrease by performing a division operation on the decreasing amplitude and the set maximum allowable power supply current in step S220, and in this case, the decreasing amplitude should be greater than 1.

Of course, it should be understood that the decreasing amplitude may also be applied to the set maximum allowable power supply current in step S220 by any other suitable algorithm, as long as the maximum allowable power supply current can decrease by adopting the algorithm.

In one possible implementation, based on the ratio of the height of the conductors in the stator slot of the motor to the skin depth, the identification of the conductors, and the set maximum allowable power supply current, the target maximum allowable power supply current can be calculated by employing the following equations:

$$I_m = \frac{I_b}{\sqrt{\varphi(\xi) + N(N-1)\psi(\xi)}} \quad \text{(Equation 5)},$$

$$\varphi(\xi) = \xi \frac{sh(2\xi) + \sin(2\xi)}{ch(2\xi) - \cos(2\xi)} \quad \text{(Equation 6)},$$

$$\psi(\xi) = 2\xi \frac{sh(\xi) - \sin(\xi)}{ch(\xi) + \cos(\xi)} \quad \text{(Equation 7)},$$

wherein $I_m$ represents the target maximum allowable power supply current, $I_b$ represents the set maximum allowable power supply current, $\xi$ represents the ratio of the height of the conductors to the skin depth, and N represents the identification of the conductors.

In step S260, the adjusted maximum allowable power supply current is used for continuing to test the peak performance of the motor. Step S260 corresponds to a continuous testing step.

In the present embodiment, before the rotational speed of the motor reaches the predetermined rotational speed, the motor controller can test the peak performance of the motor by using the set maximum allowable power supply current in step S220. When the rotational speed of the motor reaches the predetermined rotational speed, the motor controller adjusts the set maximum allowable power supply current in step S220 to decrease it, and then the motor controller can use the adjusted maximum allowable power supply current for continuing to test the peak performance of the motor.

According to the method for testing the performance of the motor in the present embodiment, the peak performance of the motor is tested by using the set maximum allowable power supply current, during which if the rotational speed of the motor reaches the predetermined rotational speed, the set maximum allowable power supply current decreases with the increase of the rotational speed of the motor, and the adjusted maximum allowable power supply current is used for continuing to test the peak performance of the motor. Therefore, compared with the prior art which only considers the current limitation and/or voltage limitation without considering the skin effect when testing the peak performance of the motor, the present embodiment considers not only the current limitation but also the skin effect when testing the peak performance of the motor. Hence, by decreasing the maximum allowable power supply current applied to the motor when the rotational speed of the motor reaches the predetermined rotational speed, the maximum copper loss density can be maintained substantially constant with the increase of the rotational speed of the motor.

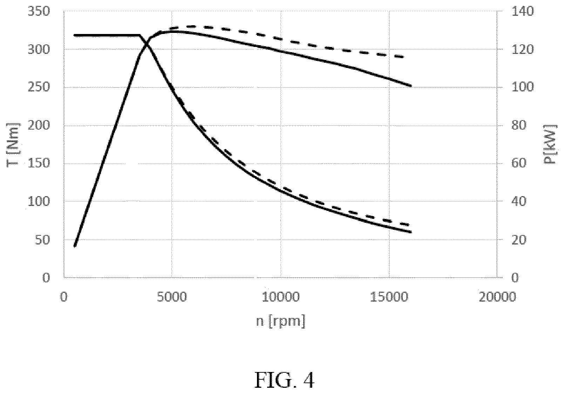

FIG. 4 is a schematic diagram of comparison of the peak performance of the motor after applying the methods for testing the peak performance of the motor in the present embodiment and the related art. In FIG. 4, the symbols "T", "P" and "n" represent the peak torque, the peak power and the rotational speed, respectively, the solid line represents a curve obtained by testing the peak performance of the motor adopting the method for testing the peak performance of the motor in the present embodiment, and the dotted line represents a curve obtained by testing the peak performance of the motor adopting the method for testing the peak performance of the motor in the prior art.

As shown in FIG. 4, before the rotational speed of the motor reaches 5000 rpm, the peak torque obtained by adopting the method for testing the peak performance of the motor in the present embodiment is substantially consistent with the peak torque obtained by adopting the method for testing the peak performance of the motor in the prior art, and the peak power obtained by adopting the method for testing the peak performance of the motor in the present embodiment is also substantially consistent with the peak power obtained by adopting the method for testing the peak performance of the motor in the prior art. However, when the rotational speed of the motor reaches 5000 rpm, at the same rotational speed point, the peak torque obtained by adopting the method for testing the peak performance of the motor in the present embodiment is smaller than the peak torque obtained by adopting the method for testing the peak performance of the motor in the prior art, and the peak power obtained by adopting the method for testing the peak performance of the motor in the present embodiment is also smaller than the peak power obtained by adopting the method for testing the peak performance of the motor in the prior art.

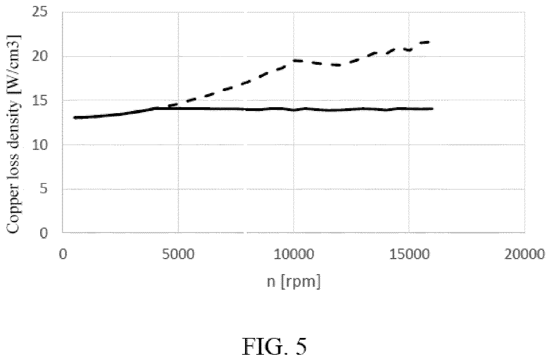

FIG. 5 is a schematic diagram of comparison of the copper loss density in last conductors of stator slots after applying the methods for testing the peak performance of the motor in the present embodiment and the related art. In FIG. 5, the symbol "n" represents the rotational speed, the solid line represents a curve obtained by testing the peak performance of the motor adopting the method for testing the peak performance of the motor in the present embodiment, and the dotted line represents a curve obtained by testing the peak performance of the motor adopting the method for testing the peak performance of the motor in the prior art.

As shown in FIG. 5, before the rotational speed of the motor reaches 5000 rpm, the copper loss density in the last conductor of the stator slot obtained by adopting the methods for testing the peak performance of the motor in the present embodiment and the prior art are substantially consistent. However, when the rotational speed of the motor reaches 5000 rpm, the copper loss density in the last conductor of the stator slot obtained by adopting the method for testing the peak performance of the motor in the prior art increases with the increase of the rotational speed, while the copper loss density in the last conductor of the stator slot obtained by adopting the method for testing the peak performance of the motor in the present embodiment is maintained substantially constant with the increase of the rotational speed.

In one possible implementation, the above setting and testing step may comprise: setting the maximum allowable power supply current of the motor and the maximum allowable power supply voltage of the motor; calculating the electromagnetic torque and the phase voltage of the motor corresponding to each rotational speed of the motor according to the set lead angle and current test step size; and filtering out the electromagnetic torque and phase voltage corresponding to the rotational speed at which the phase voltage exceeds the maximum allowable power supply voltage.

In the present embodiment, the motor controller may test the peak performance of the motor by using the set maximum allowable power supply current by adopting the related method shown in FIG. 1. Exemplarily, in addition to setting the maximum allowable power supply current, the maximum allowable power supply voltage of the motor may also be set; the lead angle and the current test step size may be set; the electromagnetic torque and the phase voltage of the motor corresponding to each rotational speed of the motor may be calculated according to the set lead angle and current test step size; and rotational speed points with voltage exceeding the maximum allowable power supply voltage are filtered out by scanning all rotational speed points. For detailed description, please refer to the previous description about steps S110-S140. Due to space limitations, details will not be repeated here.

In one possible implementation, the adjustment step may comprise: after the electromagnetic torque and the phase voltage corresponding to the rotational speed at which the phase voltage exceeds the maximum allowable power supply voltage are filtered out, when the rotational speed of the motor reaches the predetermined rotational speed, enabling the set maximum allowable power supply current to decrease with the increase of the rotational speed of the motor.

In the present embodiment, the motor controller may, for example, scan all rotational speed points to filter out the electromagnetic torque and the phase voltage corresponding to the rotational speed point with the phase voltage exceeding the maximum allowable power supply voltage $U_m$. For the remaining rotational speed points after filtering, the set maximum allowable power supply current in step S220 is adjusted by adopting a manner of above step S240.

In one possible implementation, the continuous testing step may comprise: generating a peak torque curve of the motor representing the peak torque performance of the motor based on the maximum electromagnetic torque (i.e., peak torque) corresponding to each remaining rotational speed; and generating a peak power curve of the motor representing the peak power performance of the motor based on the maximum power (i.e., peak power) corresponding to each remaining rotational speed.

In the present embodiment, multiple points of the peak torque corresponding to each remaining rotational speed can be connected, thereby forming the peak torque curve; accordingly, multiple points of the peak power corresponding to each remaining rotational speed can be connected, thereby forming the peak power curve; and a user can know the peak performance of the motor based on the peak torque curve and the peak power curve.

In one possible implementation, the setting and testing step may comprise: setting the maximum allowable power supply voltage and the maximum allowable power supply current of the motor based on the current and voltage capacities of a battery and a power control unit PEU of the new energy vehicle. For details, please refer to the previous description about step S110. Due to space limitations, details will not be repeated here.

In one possible implementation, calculating the phase voltage corresponding to each rotational speed of the motor comprises: obtaining a D-axis output voltage and a Q-axis output voltage under a rotational coordinate system corresponding to each rotational speed of the motor; and calculating the phase voltage corresponding to each rotational speed based on the obtained D-axis output voltage and Q-axis output voltage corresponding to each rotational speed.

Exemplarily, the motor controller may obtain the D-axis output voltage and the Q-axis output voltage respectively by employing Equation 2 and Equation 3, and then calculate the corresponding phase voltage by employing Equation 4.

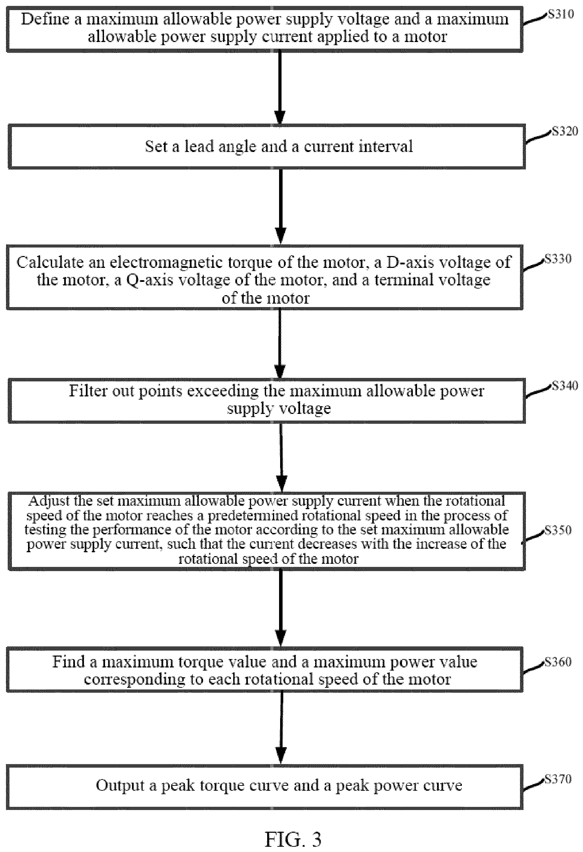

The following description acts as a specific example of the method for testing the peak performance of the motor in the present embodiment. FIG. 3 is an exemplary flow chart of the method for testing the peak performance of the motor according to an exemplary embodiment. As shown in FIG. 3, the method for testing the peak performance of the motor may comprise:

In step S310, the maximum allowable power supply voltage and the maximum allowable power supply current applied to the motor are defined. For details about this step, please refer to the previous description about steps S110 and S220. Due to space limitations, details will not be repeated here.

In step S320, the lead angle and current interval are set. For details about this step, please refer to the previous description about steps S120 and S220. Due to space limitations, details will not be repeated here.

In step S330, the electromagnetic torque of the motor, the D-axis voltage of the motor, the Q-axis voltage of the motor, and the terminal voltage of the motor are calculated. For details about this step, please refer to the previous description about steps S130 and S220. Due to space limitations, details will not be repeated here.

In step S340, points exceeding the maximum allowable power supply voltage are filtered out. For details about this step, please refer to the previous description about steps S140 and S220. Due to space limitations, details will not be repeated here.

In step S350, the set maximum allowable power supply current is adjusted when the rotational speed of the motor reaches a predetermined rotational speed in the process of testing the performance of the motor according to the set maximum allowable power supply current, such that the current decreases with the increase of the rotational speed of the motor. For details about this step, please refer to the previous description about step S240. Due to space limitations, details will not be repeated here.

In step S360, a maximum torque value and a maximum power value corresponding to each rotational speed of the motor are found. For details about this step, please refer to the previous description about steps S150 and S220. Due to space limitations, details will not be repeated here.

In step S370, a peak torque curve and a peak power curve are outputted. For details about this step, please refer to the previous description about steps S160 and S220. Due to space limitations, details will not be repeated here.

By comparing FIG. 1 with FIG. 3, it can be seen that compared with the prior art, in the method for testing the performance of the motor in the present embodiment, step S350 of enabling the set maximum allowable power supply current to decrease with the increase of the rotational speed of the motor when the rotational speed of the motor reaches the predetermined speed is added. Therefore, it can be ensured that the maximum copper loss density can be maintained substantially constant with the increase of the rotational speed of the motor when the motor is running at high speeds, thereby avoiding the influence of the skin effect.

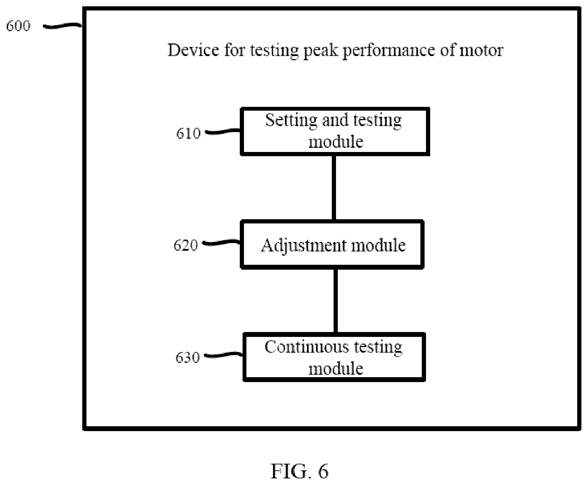

FIG. 6 is a block diagram of the device for testing the peak performance of the motor shown by an exemplary embodiment. The device for testing the peak performance of the motor can be applied to the flat wire motor of the new energy vehicle. As shown in FIG. 6, the device for testing the peak performance of the motor 600 may comprise a setting and testing module 610, an adjustment module 620, and a continuous testing module 630.

The setting and testing module 610 is used for setting a maximum allowable power supply current of the motor, and testing the peak performance of the motor by using the set maximum allowable power supply current. The adjustment module 620 is connected to the setting and testing module 610, and used for adjusting the set maximum allowable power supply current when the rotational speed of the motor reaches a predetermined rotational speed in the process of testing the performance of the motor according to the set maximum allowable power supply current, such that the current decreases with the increase of the rotational speed of the motor. The continuous testing module 630 is connected to the adjustment module 620, and used for continuing to test the peak performance of the motor by using the adjusted maximum allowable power supply current.

In one possible implementation, the adjustment module 620 is configured to: calculate a ratio of the height of conductors in a stator slot of the motor to the skin depth; calculate a target maximum allowable power supply current based on the ratio, identification of the conductors, and the set maximum allowable power supply current; and adjust the set maximum allowable power supply current to the calculated target maximum allowable power supply current, wherein the target maximum allowable power supply current is less than the set maximum allowable power supply current.

In one possible implementation, the adjustment module 620 is configured to: based on the ratio, the identification of the conductors, and the set maximum allowable power supply current, calculate the target maximum allowable power supply current by employing the following equations:

$$I_m = \frac{I_b}{\sqrt{\varphi(\xi) + N(N-1)\psi(\xi)}}, \qquad \varphi(\xi) = \xi\,\frac{sh(2\xi)+\sin(2\xi)}{ch(2\xi)-\cos(2\xi)}, \text{ and } \quad \psi(\xi) = 2\xi\,\frac{sh(\xi)-\sin(\xi)}{ch(\xi)+\cos(\xi)},$$

wherein $I_m$ represents the target maximum allowable power supply current, $I_b$ represents the set maximum allowable power supply current, $\xi$ represents the ratio of the height of the conductors to the skin depth, and N represents the identification of the conductors.

In one possible implementation, the setting and testing module 610 is configured to: set the maximum allowable power supply current of the motor and the maximum allowable power supply voltage of the motor; calculate the electromagnetic torque and the phase voltage of the motor corresponding to each rotational speed of the motor according to the set lead angle and current test step size; and filter out the electromagnetic torque and the phase voltage corresponding to the rotational speed at which the phase voltage exceeds the maximum allowable power supply voltage.

In one possible implementation, the adjustment module 620 is configured to: after the electromagnetic torque and the phase voltage corresponding to the rotational speed at which the phase voltage exceeds the maximum allowable power supply voltage are filtered out, when the rotational speed of the motor reaches the predetermined rotational speed, enabling the set maximum allowable power supply current to decrease with the increase of the rotational speed of the motor.

In one possible implementation, the continuous testing module 630 is configured to: generate a peak torque curve of the motor representing the peak torque performance of the motor based on the maximum electromagnetic torque corresponding to each remaining rotational speed; and generate a peak power curve of the motor representing the peak power performance of the motor based on the maximum power corresponding to each remaining rotational speed.

In one possible implementation, the setting and testing module 610 is configured to: set the maximum allowable power supply voltage and the maximum allowable power supply current of the motor based on the current and voltage capacities of a battery and a power control unit PEU of the new energy vehicle.

In one possible implementation, the setting and testing module 610 is configured to: obtain a D-axis output voltage and a Q-axis output voltage under a rotational coordinate system corresponding to each rotational speed of the motor; and calculate the phase voltage corresponding to the rotational speed based on the obtained D-axis output voltage and Q-axis output voltage corresponding to each rotational speed.

Regarding the apparatus in the above embodiment, the specific ways in which each module executes operations have been described in detail in the embodiments related to the method, and will not be described in detail here.

The above is only specific embodiments of the present invention, but the protection scope of the present invention is not limited thereto, and any change or substitution that may be easily thought of by those skilled in the art within the technical scope disclosed by the present invention should be covered within the protection scope of the present invention. Therefore, the protection scope of the present invention shall be subject to the protection scope of the claims.

**Claims**

1. A method for testing peak performance of a motor (600), applied to a flat wire motor (600) of a new energy vehicle, the method comprising: a setting and testing step (S110, S120, S130, S160, S220, S240, S260, S310, S320, S330, S340, S350, S360, S370) of setting a maximum allowable power supply current of the motor (600), and testing the peak performance of the motor (600) by using the set maximum allowable power supply current;
   **characterized by**:
   an adjustment step (S110, S120, S130, S160, S220, S240, S260, S310, S320, S330, S340, S350, S360, S370) of adjusting the set maximum allowable power supply current when a rotational speed of the motor reaches (5000) a predetermined rotational speed in the process of testing the performance of the motor (600) according to the set maximum allowable power supply current, such that the current decreases with an increase of the rotational speed of the motor (600); and a continuous testing step (S110, S120, S130, S160, S220, S240, 5260, S310, S320, S330, S340, S350, S360, S370) of continuing to test the peak performance of the motor (600) by using the adjusted maximum allowable power supply current.

2. The method for testing the peak performance of the motor according to Claim 1, **characterized in that** in the adjustment step:

   a ratio of the height of conductors in a stator slot of the motor to the skin depth is calculated;
   a target maximum allowable power supply current is calculated based on the ratio, identification of the conductors, and the set maximum allowable power supply current; and
   the set maximum allowable power supply current is adjusted to the calculated target maximum allowable power supply current, wherein the target maximum allowable power supply current is less than the set maximum allowable power supply current.

3. The method for testing the peak performance of the motor according to Claim 2, **characterized in that** in the adjustment step, based on the ratio, the identification of the conductors, and the set maximum allowable power supply current, the target maximum allowable power supply current is calculated by employing the following equations:

$$I_m = \frac{I_b}{\sqrt{\varphi(\xi) + N(N-1)\psi(\xi)}}, \quad \varphi(\xi) = \xi\frac{sh(2\xi)+\sin(2\xi)}{ch(2\xi)-\cos(2\xi)}, \quad \psi(\xi) = 2\xi\frac{sh(\xi)-\sin(\xi)}{ch(\xi)+\cos(\xi)},$$

   wherein $I_m$ represents the target maximum allowable power supply current, $I_b$ represents the set maximum allowable power supply current, $\xi$ represents the ratio of the height of the conductors to the skin depth, and N represents the identification of the conductors.

4. The method for testing the peak performance of the motor according to any one of Claims 1-3, **characterized in that** the setting and testing step comprises:

   setting the maximum allowable power supply current of the motor and the maximum allowable power supply voltage of the motor;
   calculating an electromagnetic torque and a phase voltage of the motor corresponding to each rotational speed of the motor according to a set lead angle and current test step size; and
   filtering out the electromagnetic torque and the phase voltage corresponding to the rotational speed at which the phase voltage exceeds the maximum allowable power supply voltage.

5. The method for testing the peak performance of the motor according to Claim 4, **characterized in that** the adjustment step comprises:
after the electromagnetic torque and the phase voltage corresponding to the rotational speed at which the phase voltage exceeds the maximum allowable power supply voltage are filtered out, when the rotational speed of the motor reaches the predetermined rotational speed, enabling the set maximum allowable power supply current to decrease with an increase of the rotational speed of the motor.

6. The method for testing the peak performance of the motor according to Claim 5, **characterized in that** the continuous testing step comprises:

generating a peak torque curve of the motor representing peak torque performance of the motor based on a maximum electromagnetic torque corresponding to each remaining rotational speed; and
generating a peak power curve of the motor representing peak power performance of the motor based on a maximum power corresponding to each remaining rotational speed.

7. The method for testing the peak performance of the motor according to Claim 4, **characterized in that** the setting and testing step comprises:
setting the maximum allowable power supply voltage and the maximum allowable power supply current of the motor based on current and voltage capacities of a battery and a power control unit PEU of the new energy vehicle.

8. The method for testing the peak performance of the motor according to Claim 4, **characterized in that** calculating the phase voltage corresponding to each rotational speed of the motor comprises:

obtaining a D-axis output voltage and a Q-axis output voltage under a rotational coordinate system corresponding to each rotational speed of the motor; and
calculating the phase voltage corresponding to the rotational speed based on the obtained D-axis output voltage and Q-axis output voltage corresponding to each rotational speed.

9. A device for testing peak performance of a motor (600), applied to a flat wire motor (600) of a new energy vehicle, the device comprising: a setting and testing module (610), used for setting a maximum allowable power supply current of the motor (600), and testing the peak performance of the motor (600) by using the set maximum allowable power supply current;
**characterized by**:
an adjustment module (620), connected to the setting and testing module (610), and used for adjusting the set maximum allowable power supply current when a rotational speed of the motor reaches (5000) a predetermined rotational speed in the process of testing the performance of the motor (600) according to the set maximum allowable power supply current, such that the current decreases with an increase of the rotational speed of the motor (600); and a continuous testing module (630), connected to the adjustment module (620), and used for continuing to test the peak performance of the motor (600) by using the adjusted maximum allowable power supply current.

10. The device for testing the peak performance of the motor according to Claim 9, **characterized in that** the adjustment module is configured to:

calculate a ratio of the height of conductors in a stator slot of the motor to the skin depth;
calculate a target maximum allowable power supply current based on the ratio, identification of the conductors, and the set maximum allowable power supply current; and
adjust the set maximum allowable power supply current to the calculated target maximum allowable power supply current, wherein the target maximum allowable power supply current is less than the set maximum allowable power supply current.

11. The device for testing the peak performance of the motor according to Claim 10, **characterized in that** the adjustment module is configured to: based on the ratio, the identification of the conductors, and the set maximum allowable power supply current, calculate the target maximum allowable power supply current by employing the following equations:

$$I_m = \frac{I_b}{\sqrt{\varphi(\xi) + N(N-1)\psi(\xi)}}, \quad \varphi(\xi) = \xi\frac{sh(2\xi) + \sin(2\xi)}{ch(2\xi) - \cos(2\xi)}, \quad \psi(\xi) = 2\xi\frac{sh(\xi) - \sin(\xi)}{ch(\xi) + \cos(\xi)},$$

wherein $I_m$ represents the target maximum allowable power supply current, $I_b$ represents the set maximum allowable power supply current, $\xi$ represents the ratio of the height of the conductors to the skin depth, and N represents the identification of the conductors.

12. The device for testing the peak performance of the motor according to any one of Claims 9-11, **characterized in that** the setting and testing module is configured to:

> set the maximum allowable power supply current of the motor and the maximum allowable power supply voltage of the motor;
> calculate an electromagnetic torque and a phase voltage of the motor corresponding to each rotational speed of the motor according to a set lead angle and current test step size; and
> filter out the electromagnetic torque and the phase voltage corresponding to the rotational speed at which the phase voltage exceeds the maximum allowable power supply voltage.

13. The device for testing the peak performance of the motor according to Claim 12, **characterized in that** the adjustment module is configured to:
after the electromagnetic torque and the phase voltage corresponding to the rotational speed at which the phase voltage exceeds the maximum allowable power supply voltage are filtered out, when the rotational speed of the motor reaches the predetermined rotational speed, enable the set maximum allowable power supply current to decrease with an increase of the rotational speed of the motor.

14. The device for testing the peak performance of the motor according to Claim 13, **characterized in that** the continuous testing module is configured to:

> generate a peak torque curve of the motor representing peak torque performance of the motor based on a maximum electromagnetic torque corresponding to each remaining rotational speed; and
> generate a peak power curve of the motor representing peak power performance of the motor based on a maximum power corresponding to each remaining rotational speed.

15. The device for testing the peak performance of the motor according to Claim 12, **characterized in that** the setting and testing module is configured to:
set the maximum allowable power supply voltage and the maximum allowable power supply current of the motor based on current and voltage capacities of a battery and a power control unit PEU of the new energy vehicle.

16. The device for testing the peak performance of the motor according to Claim 12, **characterized in that** the setting and testing module is configured to:

> obtain a D-axis output voltage and a Q-axis output voltage under a rotational coordinate system corresponding to each rotational speed of the motor; and
> calculate the phase voltage corresponding to the rotational speed based on the obtained D-axis output voltage and Q-axis output voltage corresponding to each rotational speed.

**Patentansprüche**

1. Verfahren zum Testen einer Spitzenleistung eines Motors (600), angewendet auf einen Flachdrahtmotor (600) eines New-Energy-Vehicles, wobei das Verfahren Folgendes umfasst:

> einen Einstell- und Testschritt (S110, S120, S130, S160, S220, S240, S260, S310, S320, S330, S340, S350, S360, S370) des Einstellens eines maximal zulässigen Versorgungsstroms des Motors (600) und des Testens der Spitzenleistung des Motors (600) unter Verwendung des eingestellten maximal zulässigen Versorgungsstroms;
> **gekennzeichnet durch**:
> einen Anpassungsschritt (S110, S120, S130, S160, S220, S240, S260, S310, S320, S330, S340, S350, S360, S370) des Anpassens des eingestellten maximal zulässigen Versorgungsstroms, wenn eine Drehzahl des Motors (5000) in dem Prozess des Testens der Leistung des Motors (600) gemäß dem eingestellten maximal zulässigen Versorgungsstrom eine vorbestimmte Drehzahl derart erreicht, dass der Strom mit einem Anstieg der Drehzahl des Motors (600) abnimmt; und einen Schritt des kontinuierlichen Testens (S110, S120, S130, S160, S220, S240, S260, S310, S320, S330, S340, S350, S360, S370) des Fortsetzens des Tests der Spitzenleistung des Motors (600) unter Verwendung des angepassten maximal zulässigen Versorgungsstroms.

2. Verfahren zum Testen der Spitzenleistung des Motors nach Anspruch 1, **dadurch gekennzeichnet, dass** in dem Anpassungsschritt:

ein Verhältnis der Leiterhöhe in einer Statornut des Motors zu der Eindringtiefe berechnet wird;
ein Zielwert des maximal zulässigen Versorgungsstroms basierend auf dem Verhältnis, Kennzeichnung der Leiter und dem eingestellten maximal zulässigen Versorgungsstrom berechnet wird; und
der eingestellte maximal zulässige Versorgungsstrom an den berechneten Zielwert des maximal zulässigen Versorgungsstroms angepasst wird, wobei der Zielwert des maximal zulässigen Versorgungsstroms kleiner ist als der eingestellte maximal zulässige Versorgungsstrom.

3. Verfahren zum Testen der Spitzenleistung des Motors nach Anspruch 2, **dadurch gekennzeichnet, dass** der Zielwert des maximal zulässigen Versorgungsstroms in dem Anpassungsschritt basierend auf dem Verhältnis, der Kennzeichnung der Leiter und des eingestellten maximal zulässigen Versorgungsstroms durch Nutzen der folgenden Gleichungen berechnet wird:

$$I_m = \frac{I_b}{\sqrt{\varphi(\xi) + N(N-1)\psi(\xi)}}, \; \varphi(\xi) = \xi \frac{sh(2\xi) + \sin(2\xi)}{ch(2\xi) - \cos(2\xi)}, \; \psi(\xi) = 2\xi \frac{sh(\xi) - \sin(\xi)}{ch(\xi) + \cos(\xi)},$$

wobei $I_m$ den Zielwert des maximal zulässigen Versorgungsstroms darstellt, $I_b$ den eingestellten maximal zulässigen Versorgungsstrom darstellt, $\xi$ das Verhältnis der Leiterhöhe zu der Eindringtiefe darstellt und N die Kennzeichnung der Leiter darstellt.

4. Verfahren zum Testen der Spitzenleistung des Motors nach einem der Ansprüche 1 bis 3, **dadurch gekennzeichnet, dass** der Einstell- und Testschritt Folgendes umfasst:

Einstellen des maximal zulässigen Versorgungsstroms des Motors und der maximal zulässigen Versorgungsspannung des Motors;
Berechnen eines elektromagnetischen Drehmoments und einer Phasenspannung des Motors, die jeder Drehzahl des Motors entsprechen, gemäß einem eingestellten Vorlaufwinkel und einer eingestellten Testschrittweite für Strom; und
Herausfiltern des elektromagnetischen Drehmoments und der Phasenspannung, die der Drehzahl entsprechen, bei der die Phasenspannung die maximal zulässige Versorgungsspannung überschreitet.

5. Verfahren zum Testen der Spitzenleistung des Motors nach Anspruch 4, **dadurch gekennzeichnet, dass** der Anpassungsschritt Folgendes umfasst:
Ermöglichen eines Abnehmens des eingestellten maximal zulässigen Versorgungsstroms mit einem Anstieg der Drehzahl des Motors, wenn die Drehzahl des Motors die vorbestimmte Drehzahl erreicht, nach Herausfiltern des elektromagnetischen Drehmoments und der Phasenspannung, die der Drehzahl entsprechen, bei der die Phasenspannung die maximal zulässige Versorgungsspannung überschreitet.

6. Verfahren zum Testen der Spitzenleistung des Motors nach Anspruch 5, **dadurch gekennzeichnet, dass** der Schritt des kontinuierlichen Testens Folgendes umfasst:

Erzeugen einer Spitzendrehmomentkurve des Motors, die die Drehmoment-Spitzenleistung des Motors basierend auf einem maximalen elektromagnetischen Drehmoment, das jeder verbleibenden Drehzahl entspricht, darstellt; und
Erzeugen einer Spitzenversorgungskurve des Motors, die die Versorgungs-Spitzenleistung des Motors basierend auf einer maximalen Versorgung, die jeder verbleibenden Drehzahl entspricht, darstellt.

7. Verfahren zum Testen der Spitzenleistung des Motors nach Anspruch 4, **dadurch gekennzeichnet, dass** der Einstell- und Testschritt Folgendes umfasst:
Einstellen der maximal zulässigen Versorgungsspannung und des maximal zulässigen Versorgungsstroms des Motors basierend auf der Strom- und Spannungskapazität einer Batterie und einer Versorgungssteuereinheit (PEU) des New-Energy-Vehicles.

8. Verfahren zum Testen der Spitzenleistung des Motors nach Anspruch 4, **dadurch gekennzeichnet, dass** das Berechnen der Phasenspannung, die jeder Drehzahl des Motors entspricht, Folgendes umfasst:

Erhalten einer D-Achsen-Ausgangsspannung und einer Q-Achsen-Ausgangsspannung in einem Rotationskoordinatensystem, die jeder Drehzahl des Motors entsprechen; und
Berechnen der Phasenspannung, die der Drehzahl entspricht, basierend auf der erhaltenen D-Achsen-Ausgangsspannung und Q-Achsen-Ausgangsspannung, die jeder Drehzahl entsprechen.

9. Vorrichtung zum Testen der Spitzenleistung eines Motors (600), angewendet auf einen Flachdrahtmotor (600) eines New-Energy-Vehicles, wobei die Vorrichtung Folgendes umfasst:

ein Einstell- und Testmodul (610), das zum Einstellen eines maximal zulässigen Versorgungsstroms des Motors (600) und Testen der Spitzenleistung des Motors (600) unter Verwendung des eingestellten maximal zulässigen Versorgungsstroms verwendet wird;
**gekennzeichnet durch**:
ein Anpassungsmodul (620), das mit dem Einstell- und Testmodul (610) verbunden ist und zum Anpassen des eingestellten maximal zulässigen Versorgungsstroms verwendet wird, wenn eine Drehzahl des Motors (5000) in dem Prozess des Testens der Leistung des Motors (600) gemäß dem eingestellten maximal zulässigen Versorgungsstrom eine vorbestimmte Drehzahl derart erreicht, dass der Strom mit einem Anstieg der Drehzahl des Motors (600) abnimmt; und ein Modul für kontinuierliches Testen (630), das mit dem Anpassungsmodul (620) verbunden ist und zum Fortsetzen des Tests der Spitzenleistung des Motors (600) unter Verwendung des angepassten maximal zulässigen Versorgungsstroms verwendet wird.

10. Vorrichtung zum Testen der Spitzenleistung des Motors nach Anspruch 9, **dadurch gekennzeichnet, dass** das Anpassungsmodul zu Folgendem konfiguriert ist:

Berechnen eines Verhältnisses der Leiterhöhe in einer Statornut des Motors zu der Eindringtiefe;
Berechnen eines Zielwerts des maximal zulässigen Versorgungsstroms basierend auf dem Verhältnis, Kennzeichnung der Leiter und dem eingestellten maximal zulässigen Versorgungsstrom; und
Anpassen des eingestellten maximal zulässigen Versorgungsstroms an den berechneten Zielwert des maximal zulässigen Versorgungsstroms, wobei der Zielwert des maximal zulässigen Versorgungsstroms kleiner ist als der eingestellte maximal zulässige Versorgungsstrom.

11. Vorrichtung zum Testen der Spitzenleistung des Motors nach Anspruch 10, **dadurch gekennzeichnet, dass** das Anpassungsmodul zu Folgendem konfiguriert ist: Berechnen des Zielwerts des maximal zulässigen Versorgungsstroms basierend auf dem Verhältnis, der Kennzeichnung der Leiter und des eingestellten maximal zulässigen Versorgungsstroms durch Nutzen der folgenden Gleichungen:

$$I_m = \frac{I_b}{\sqrt{\varphi(\xi) + N(N-1)\psi(\xi)}}, \; \varphi(\xi) = \xi \frac{sh(2\xi) + \sin(2\xi)}{ch(2\xi) - \cos(2\xi)}, \; \psi(\xi) = 2\xi \frac{sh(\xi) - \sin(\xi)}{ch(\xi) + \cos(\xi)},$$

wobei $I_m$ den Zielwert des maximal zulässigen Versorgungsstroms darstellt, $I_b$ den eingestellten maximal zulässigen Versorgungsstrom darstellt, $\xi$ das Verhältnis der Leiterhöhe zu der Eindringtiefe darstellt und N die Kennzeichnung der Leiter darstellt.

12. Vorrichtung zum Testen der Spitzenleistung des Motors nach einem der Ansprüche 9 bis 11, **dadurch gekennzeichnet, dass** das Einstell- und Testmodul zu Folgendem konfiguriert ist:

Einstellen des maximal zulässigen Versorgungsstroms des Motors und der maximal zulässigen Versorgungsspannung des Motors;
Berechnen eines elektromagnetischen Drehmoments und einer Phasenspannung des Motors, die jeder Drehzahl des Motors entsprechen, gemäß einem eingestellten Vorlaufwinkel und einer eingestellten Testschrittweite für Strom; und
Herausfiltern des elektromagnetischen Drehmoments und der Phasenspannung, die der Drehzahl entsprechen, bei der die Phasenspannung die maximal zulässige Versorgungsspannung überschreitet.

13. Vorrichtung zum Testen der Spitzenleistung des Motors nach Anspruch 12, **dadurch gekennzeichnet, dass** das Anpassungsmodul zu Folgendem konfiguriert ist:

Ermöglichen eines Abnehmens des eingestellten maximal zulässigen Versorgungsstroms mit einem Anstieg der Drehzahl des Motors, wenn die Drehzahl des Motors die vorbestimmte Drehzahl erreicht, nach Herausfiltern des elektromagnetischen Drehmoments und der Phasenspannung, die der Drehzahl entsprechen, bei der die Phasenspannung die maximal zulässige Versorgungsspannung überschreitet.

**14.** Vorrichtung zum Testen der Spitzenleistung des Motors nach Anspruch 13, **dadurch gekennzeichnet, dass** das Modul für kontinuierliches Testen zu Folgendem konfiguriert ist:

Erzeugen einer Spitzendrehmomentkurve des Motors, die die Drehmoment-Spitzenleistung des Motors basierend auf einem maximalen elektromagnetischen Drehmoment, das jeder verbleibenden Drehzahl entspricht, darstellt; und

Erzeugen einer Spitzenversorgungskurve des Motors, die die maximale Versorgungs-Spitzenleistung des Motors basierend auf einer maximalen Versorgung, die jeder verbleibenden Drehzahl entspricht, darstellt.

**15.** Vorrichtung zum Testen der Spitzenleistung des Motors nach Anspruch 12, **dadurch gekennzeichnet, dass** das Einstell- und Testmodul zu Folgendem konfiguriert ist:

Einstellen der maximal zulässigen Versorgungsspannung und des maximal zulässigen Versorgungsstroms des Motors basierend auf der Strom- und Spannungskapazität einer Batterie und einer Versorgungssteuereinheit (PEU) des New-Energy-Vehicles.

**16.** Vorrichtung zum Testen der Spitzenleistung des Motors nach Anspruch 12, **dadurch gekennzeichnet, dass** das Einstell- und Testmodul zu Folgendem konfiguriert ist:

Erhalten einer D-Achsen-Ausgangsspannung und einer Q-Achsen-Ausgangsspannung in einem Rotationskoordinatensystem, die jeder Drehzahl des Motors entsprechen; und

Berechnen der Phasenspannung, die der Drehzahl entspricht, basierend auf der erhaltenen D-Achsen-Ausgangsspannung und Q-Achsen-Ausgangsspannung, die jeder Drehzahl entsprechen.

## Revendications

**1.** Procédé pour tester les performances maximales d'un moteur (600), appliqué à un moteur à fil plat (600) d'un véhicule à énergie nouvelle, le procédé comprenant : une étape de définition et de test (S110, S120, S130, S160, S220, S240, S260, S310, S320, S330, S340, S350, S360, S370) de définition d'un courant d'alimentation électrique maximal admissible du moteur (600), et de test des performances maximales du moteur (600) en utilisant le courant d'alimentation électrique maximal admissible défini ;

**caractérisé par** :

une étape d'ajustement (S110, S120, S130, S160, S220, S240, S260, S310, S320, S330, S340, S350, S360, S370) pour ajuster le courant d'alimentation électrique maximal admissible défini lorsqu'une vitesse de rotation du moteur atteint (5000) une vitesse de rotation prédéterminée au cours du processus de test des performances du moteur (600) selon le courant d'alimentation électrique maximal admissible défini, de telle sorte que le courant diminue avec une augmentation de la vitesse de rotation du moteur (600) ; et une étape de test continu (S110, S120, S130, S160, S220, S240, S260, S310, S320, S330, S340, S350, S360, S370) de continuation du test des performances maximales du moteur (600) en utilisant le courant d'alimentation électrique maximal admissible ajusté.

**2.** Procédé pour tester les performances maximales du moteur selon la revendication 1, **caractérisé en ce que**, dans l'étape d'ajustement :

un rapport entre la hauteur des conducteurs dans une fente de stator du moteur et la profondeur de pénétration est calculé ;

un courant d'alimentation électrique maximal admissible cible est calculé en fonction du rapport, de l'identification des conducteurs et du courant d'alimentation électrique maximal admissible défini ; et

le courant d'alimentation électrique maximal admissible défini est ajusté au courant d'alimentation électrique maximal admissible cible calculé, le courant d'alimentation électrique maximal admissible cible étant inférieur au courant d'alimentation électrique maximal admissible défini.

**3.** Procédé pour tester les performances maximales du moteur selon la revendication 2, **caractérisé en ce que**, dans l'étape d'ajustement, en fonction du rapport, de l'identification des conducteurs et du courant d'alimentation électrique maximal admissible défini, le courant d'alimentation électrique maximal admissible cible est calculé en utilisant les équations suivantes :

$$I_m = \frac{I_b}{\sqrt{\varphi(\xi) + N(N-1)\psi(\xi)}}, \ \varphi(\xi) = \xi\frac{sh(2\xi)+\sin(2\xi)}{ch(2\xi)-\cos(2\xi)}, \ \psi(\xi) = 2\xi\frac{sh(\xi)-\sin(\xi)}{ch(\xi)+\cos(\xi)},$$

dans lesquelles $I_m$ représente le courant d'alimentation électrique maximal admissible cible, $I_b$ représente le courant d'alimentation électrique maximal admissible défini, $\xi$ représente le rapport entre la hauteur des conducteurs et la profondeur de pénétration, et N représente l'identification des conducteurs.

4. Procédé pour tester les performances maximales du moteur selon l'une quelconque des revendications 1 à 3, **caractérisé en ce que** l'étape de définition et de test comprend :

   la définition du courant d'alimentation électrique maximal admissible du moteur et de la tension d'alimentation électrique maximale admissible du moteur ;
   le calcul d'un couple électromagnétique et d'une tension de phase du moteur correspondant à chaque vitesse de rotation du moteur selon un angle d'avance et une taille de pas de test de courant définis ; et
   l'élimination par filtrage du couple électromagnétique et de la tension de phase correspondant à la vitesse de rotation à laquelle la tension de phase dépasse la tension d'alimentation électrique maximale admissible.

5. Procédé pour tester les performances maximales du moteur selon la revendication 4, **caractérisé en ce que** l'étape d'ajustement comprend :
   après l'élimination par filtrage du couple électromagnétique et de la tension de phase correspondant à la vitesse de rotation à laquelle la tension de phase dépasse la tension d'alimentation électrique maximale admissible, lorsque la vitesse de rotation du moteur atteint la vitesse de rotation prédéterminée, le fait de permettre au courant d'alimentation électrique maximal admissible défini de diminuer avec une augmentation de la vitesse de rotation du moteur.

6. Procédé pour tester les performances maximales du moteur selon la revendication 5, **caractérisé en ce que** l'étape de test continu comprend :

   la génération d'une courbe de couple maximal du moteur représentant des performances de couple maximal du moteur en fonction d'un couple électromagnétique maximal correspondant à chaque vitesse de rotation restante ; et
   la génération d'une courbe de puissance maximale du moteur représentant des performances de puissance maximale du moteur en fonction d'une puissance maximale correspondant à chaque vitesse de rotation restante.

7. Procédé pour tester les performances maximales du moteur selon la revendication 4, **caractérisé en ce que** l'étape de définition et de test comprend :
   la définition de la tension d'alimentation électrique maximale admissible et du courant d'alimentation électrique maximal admissible du moteur en fonction des capacités de courant et de tension d'une batterie et d'une unité de commande de puissance PEU du véhicule à énergie nouvelle.

8. Procédé pour tester les performances maximales du moteur selon la revendication 4, **caractérisé en ce que** le calcul de la tension de phase correspondant à chaque vitesse de rotation du moteur comprend :

   l'obtention d'une tension de sortie sur l'axe D et d'une tension de sortie sur l'axe Q dans un système de coordonnées rotationnelles correspondant à chaque vitesse de rotation du moteur ; et
   le calcul de la tension de phase correspondant à la vitesse de rotation en fonction de la tension de sortie d'axe D et de la tension de sortie d'axe Q obtenues correspondant à chaque vitesse de rotation.

9. Dispositif pour tester les performances maximales d'un moteur (600), appliqué à un moteur à fil plat (600) d'un véhicule à énergie nouvelle, le dispositif comprenant : un module de définition et de test (610), utilisé pour définir un courant d'alimentation électrique maximal admissible du moteur (600), et pour tester les performances maximales du moteur (600) en utilisant le courant d'alimentation électrique maximal admissible défini ;
   **caractérisé par** :
   un module d'ajustement (620), connecté au module de définition et de test (610), et utilisé pour ajuster le courant d'alimentation électrique maximal admissible défini lorsqu'une vitesse de rotation du moteur atteint (5000) une vitesse de rotation prédéterminée au cours du processus de test des performances du moteur (600) selon le courant d'alimentation électrique maximal admissible défini, de telle sorte que le courant diminue avec une augmentation de la vitesse de rotation du moteur (600) ; et un module de test continu (630), connecté au module d'ajustement (620), et utilisé pour continuer à tester les performances maximales du moteur (600) en utilisant le courant d'alimentation électrique maximal admissible ajusté.

10. Dispositif pour tester les performances maximales du moteur selon la revendication 9, **caractérisé en ce que** le module d'ajustement est configuré pour :

calculer un rapport entre la hauteur des conducteurs dans une fente de stator du moteur et la profondeur de pénétration ;
calculer un courant d'alimentation électrique maximal admissible cible en fonction du rapport, de l'identification des conducteurs et du courant d'alimentation électrique maximal admissible défini ; et
ajuster le courant d'alimentation électrique maximal admissible défini au courant d'alimentation électrique maximal admissible cible calculé, dans lequel le courant d'alimentation électrique maximal admissible cible est inférieur au courant d'alimentation électrique maximal admissible défini.

11. Dispositif pour tester les performances maximales du moteur selon la revendication 10, **caractérisé en ce que** le module d'ajustement est configuré pour : en fonction du rapport, de l'identification des conducteurs et du courant d'alimentation électrique maximal admissible défini, calculer le courant d'alimentation électrique maximal admissible cible en utilisant les équations suivantes :

$$I_m = \frac{I_b}{\sqrt{\varphi(\xi) + N(N-1)\psi(\xi)}}, \; \varphi(\xi) = \xi \frac{sh(2\xi) + \sin(2\xi)}{ch(2\xi) - \cos(2\xi)}, \; \psi(\xi) = 2\xi \frac{sh(\xi) - \sin(\xi)}{ch(\xi) + \cos(\xi)},$$

dans lesquelles $I_m$ représente le courant d'alimentation électrique maximal admissible cible, $I_b$ représente le courant d'alimentation électrique maximal admissible défini, $\xi$ représente le rapport entre la hauteur des conducteurs et la profondeur de pénétration, et N représente l'identification des conducteurs.

12. Dispositif pour tester les performances maximales du moteur selon l'une quelconque des revendications 9 à 11, **caractérisé en ce que** le module de définition et de test est configuré pour :

définir le courant d'alimentation électrique maximal admissible du moteur et la tension d'alimentation électrique maximale admissible du moteur ;
calculer un couple électromagnétique et une tension de phase du moteur correspondant à chaque vitesse de rotation du moteur selon un angle d'avance et une taille de pas de test de courant définis ; et
éliminer par filtrage le couple électromagnétique et la tension de phase correspondant à la vitesse de rotation à laquelle la tension de phase dépasse la tension d'alimentation électrique maximale admissible.

13. Dispositif pour tester les performances maximales du moteur selon la revendication 12, **caractérisé en ce que** le module d'ajustement est configuré pour :
après l'élimination par filtrage du couple électromagnétique et de la tension de phase correspondant à la vitesse de rotation à laquelle la tension de phase dépasse la tension d'alimentation électrique maximale admissible, lorsque la vitesse de rotation du moteur atteint la vitesse de rotation prédéterminée, permettre au courant d'alimentation électrique maximal admissible défini de diminuer avec une augmentation de la vitesse de rotation du moteur.

14. Dispositif pour tester les performances maximales du moteur selon la revendication 13, **caractérisé en ce que** le module de test continu est configuré pour :

générer une courbe de couple maximal du moteur représentant des performances de couple maximal du moteur en fonction d'un couple électromagnétique maximal correspondant à chaque vitesse de rotation restante ; et
générer une courbe de puissance maximale du moteur représentant des performances de puissance maximale du moteur en fonction d'une puissance maximale correspondant à chaque vitesse de rotation restante.

15. Dispositif pour tester les performances maximales du moteur selon la revendication 12, **caractérisé en ce que** le module de définition et de test est configuré pour :

définir la tension d'alimentation électrique maximale admissible et le courant d'alimentation électrique maximal admissible du moteur en fonction des capacités de courant et de tension d'une batterie et d'une unité de commande de puissance PEU du véhicule à énergie nouvelle.

16. Dispositif pour tester les performances maximales du moteur selon la revendication 12, **caractérisé en ce que** le module de définition et de test est configuré pour :

obtenir une tension de sortie sur l'axe D et une tension de sortie sur l'axe Q dans un système de coordonnées rotationnelles correspondant à chaque vitesse de rotation du moteur ; et
calculer la tension de phase correspondant à la vitesse de rotation en fonction de la tension de sortie d'axe D et de la tension de sortie d'axe Q obtenues correspondant à chaque vitesse de rotation.

Define a maximum allowable power supply voltage and a maximum allowable power supply current applied to a motor — S110

Set a lead angle and a current interval — S120

Calculate an electromagnetic torque of the motor, a D-axis voltage of the motor, a Q-axis voltage of the motor, and a terminal voltage of the motor based on the set lead angle and current interval — S130

Filter out points exceeding the maximum allowable power supply voltage by scanning all rotational speed points — S140

Find a maximum torque value and a maximum power value corresponding to each rotational speed of the motor — S150

Output a peak torque curve and a peak power curve — S160

FIG. 1

Set a maximum allowable power supply current of a motor, and test the peak performance of the motor by using the set maximum allowable power supply current ⟋S220

Adjust the set maximum allowable power supply current when the rotational speed of the motor reaches a predetermined rotational speed in the process of testing the performance of the motor according to the set maximum allowable power supply current, such that the current decreases with the increase of the rotational speed of the motor ⟋S240

Continue to test the peak performance of the motor by using the adjusted maximum allowable power supply current ⟋S260

FIG. 2

Define a maximum allowable power supply voltage and a maximum allowable power supply current applied to a motor ⟋S310

Set a lead angle and a current interval ⟋S320

Calculate an electromagnetic torque of the motor, a D-axis voltage of the motor, a Q-axis voltage of the motor, and a terminal voltage of the motor ⟋S330

Filter out points exceeding the maximum allowable power supply voltage ⟋S340

Adjust the set maximum allowable power supply current when the rotational speed of the motor reaches a predetermined rotational speed in the process of testing the performance of the motor according to the set maximum allowable power supply current, such that the current decreases with the increase of the rotational speed of the motor ⟋S350

Find a maximum torque value and a maximum power value corresponding to each rotational speed of the motor ⟋S360

Output a peak torque curve and a peak power curve ⟋S370

FIG. 3

FIG. 4

FIG. 5

FIG. 6

## REFERENCES CITED IN THE DESCRIPTION

**Patent documents cited in the description**

- CN 102490614 A